# EUROPEAN PATENT APPLICATION

(11) **EP 2 033 781 A1**
(43) Date of publication of application: **11.03.2009**
(21) Application number: 07767791.2
(22) Date of filing: 28.06.2007
(51) Int. Cl.: B41F 15/44, B41F 15/08, H05K 3/34

(54) **SQUEEGEE FOR PRINTING DEVICE, PRINTING DEVICE, AND PRINTING METHOD**

(30) Priority: 29.06.2006 JP 2006179286
(71) Applicant: YAMAHA MOTOR CO., LTD., Iwata-shi Shizuoka 438-8501 (JP)
(72) Inventor: KUSUNOKI, Toshiyuki, Iwata-shi, Shizuoka 438-8501 (JP); SATO, Takao, Iwata-shi, Shizuoka 438-8501 (JP); SUZAWA, Hideki, Iwata-shi, Shizuoka 438-8501 (JP)
(74) Representative: Müller-Boré & Partner Patentanwälte
(86) International application number: PCT/JP2007/062997
(87) International publication number: WO 2008/001845

(57) **Abstract**

[Problems]

To provide a squeegee for a printing device that achieves a satisfactory scraping ability and is readily fabricated at low costs.

[Means for Solving the Problems]

A squeegee for a printing device applies paste on a stencil 7 onto a substrate W by spreading the paste by sliding a tip end 22a along a surface of the stencil 7 disposed on the substrate W. The squeegee is formed of an expanded material made of iron and steel, and the tip end 22a is made thinner by applying a machining process to one surface alone. A thickness Ta of the tip end 22a made thinner is set to 40 to 120 µm and a length La thereof is set to 0.5 mm or greater.

## Description

### Technical Field

The present invention relates to a squeegee for a printing device that makes prints on a substrate by spreading paste on a stencil, a printing device, and a printing method.

### Background Art

There is a screen printing device configured in such a manner that a stencil (mask) for screen printing is superimposed on a substrate set at the printing position and paste, such as cream solder, supplied on the stencil is scraped and spread by the squeegee, so that the paste is printed (applied) onto the substrate at predetermined positions via openings (pattern holes) made in the stencil.

Of the printing devices of this type, the one disclosed, for example, in Patent Document 1 makes the tip end of the squeegee for scraping the cream solder thinner than the base end to increase the bending elastic coefficient at the squeegee tip end, so that the squeegee tip end achieves a better following ability with respect to the stencil. Even in the presence of winding (bending) in the stencil on the substrate, the printing device configured as above is able to lessen poor scraping, such as cream solder left unscraped by the squeegee.

Meanwhile, in a case where cream solder is applied at a position at which, for example, a CSP (chip scale package) or a microelectronic chip is to be mounted within a printing surface of the substrate, it is necessary to apply the cream solder using a printing pattern at fine pitches and it is preferable to reduce an amount of applied cream solder in comparison with the other portions. In such a case, a method frequently adopted is to make prints using a stencil (half etching mask) in which a portion (CSP portion) corresponding to the CSP mount position is made thinner.

Incidentally, in order to reduce a volume of cream solder to be applied on the CSP portion, the half etching mask is formed by a predetermined etching process (half etching) in such a manner that the portion that ultimately forms the CSP portion becomes thinner than the other portions of the stencil. More specifically, a hollow sunk below the surrounding portions is formed in a region, such as the CSP portion. In such a case, in order to print an appropriate solder pattern on the substrate, it is necessary to press the squeegee against the mask surface precisely both in a portion where a hollow is absent and in a portion where a hollow is present. However, in the half etching portion having a hollow, it is particularly difficult to press the squeegee against the mask surface and let the squeegee follow along the mask surface precisely. Such being the case, the technique to increase the bending elasticity by merely making the squeegee tip end thinner as in the conventional squeegee disclosed in Patent Document 1 fails to ensure a sufficient following ability of the squeegee with respect to the stencil, which poses a problem that it is difficult to achieve a satisfactory scraping ability.

In addition, because the squeegee in itself is already thin in Patent Document 1, when the tip end is processed further to be extremely thin, it is necessary to employ the microfabrication technique at a high degree of accuracy. This poses another problem that not only the fabrication becomes difficult, but also the cost is increased.
Patent Document 1: Japanese Patent Unexamined Publication No. HEI8-112892

### Disclosure of the Invention

The invention was devised in view of the foregoing, and has an object to provide a squeegee for a printing device that not only achieves a satisfactory scraping ability but also facilitates the fabrication at a low cost, and a printing device and a printing method using the squeegee.

The above and other technical objects can be achieved by a squeegee for a printing device of the invention configured as follows.

That is, a squeegee of the invention is a squeegee for a printing device that applies paste on a stencil onto a substrate by spreading the paste by sliding a tip end along a surface of the stencil disposed on the substrate. The squeegee is characterized by: being formed of an expanded material made of iron and steel; making the tip end thinner by applying a machining process to one surface alone; and setting a thickness of the tip end made thinner to 40 to 120 µm and a length thereof to 0.5 mm or greater.

The above and other objects can be achieved also by a printing device of the invention equipped with the squeegee and a printing method of the invention using the squeegee.

### Brief Description of the Drawings

Fig. 1 is a view schematically showing the overall configuration of a screen printing device according to one embodiment of the invention.
Fig. 2 is an enlarged cross section showing the periphery of a squeegee in the printing device of the embodiment.
Fig. 3 is a view showing the back of the squeegee employed in the printing device of the embodiment.
Fig. 4 is an enlarged side view showing a thinned tip end of the squeegee of the embodiment.
Fig. 5 is a graph showing a relation of a thickness of the thinned tip end and a thickness of unscraped solder obtained by an experiment example relating to the invention.
Fig. 6 is a graph showing a relation of a length of the thinned tip end and a thickness of unscraped solder obtained by an experiment example relating to the invention.

### Best Mode for Carrying Out the Invention

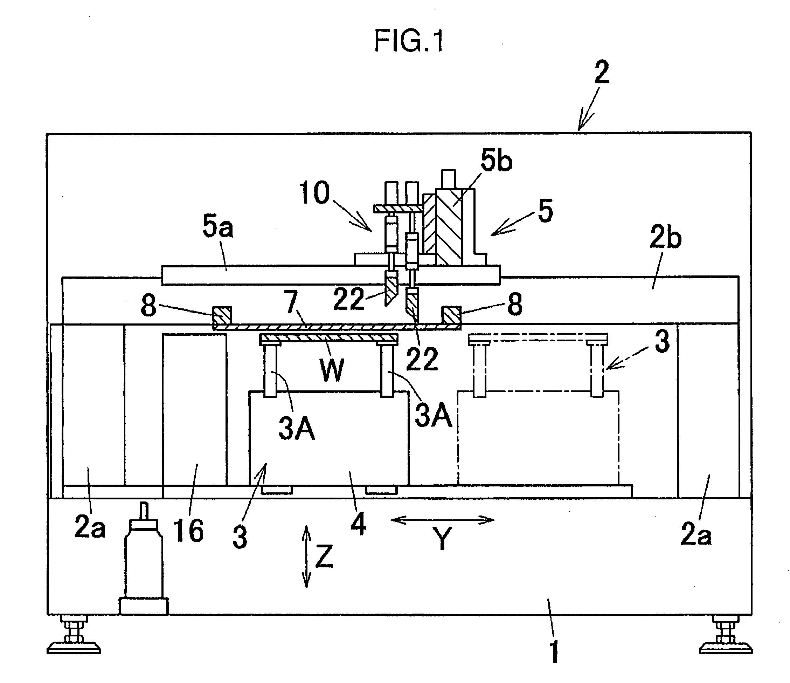

Fig. 1 is a view schematically showing the overall configuration of a screen printing device according to one embodiment of the invention. As is shown in the drawing, this printing device includes a printing device main body 2 having a base stand 1, a substrate supporting unit 3 to support a printed substrate W, and a pair of conveyers 3A and 3A to carry the substrate W in and out from the substrate supporting unit 3.

The substrate supporting unit 3 has an elevating rotation table 4 that is provided on the base stand 1. The elevating rotation table 4 is supported on an unillustrated moving mechanism to be movable in an X axis direction (a direction orthogonal to the sheet surface of Fig. 1), which is a transportation direction of the substrate W by the conveyers 3A, a Y axis direction (a left-right direction of Fig. 1) orthogonal to the X axis direction within a horizontal plane, a Z axis direction (a top-bottom direction), and an R axis direction (a rotation direction about the Z axis).

The printing device main body 2 is provided with a frame 2b shaped like a letter U when viewed in a plane and opened toward one side in the Y axis direction. The frame 2b is supported on the base stand 1 via supporting columns 2a provided to stand at the four corners of the base stand 1.

A stencil 7 is fixed to the frame 2b. To be more specific, the entire periphery of the stencil 7 is held by a frame member 8 and the frame member 8 is fixed to the frame 2b with a fixing tool, such as a bolt.

Further, a squeegee mechanism 5 is provided above the stencil 7. The squeegee mechanism 5 includes, as basic components, rail members 5a fixed to the frame 2b along edge portions on the both sides in the X axis direction and extending in the Y axis direction, a beam member 5b attached so as to bridge between the both rail members 5a and moved along the rail members 5a when driven by unillustrated moving means, a solder supply device (not shown) to supply cream solder on the stencil 7, a pair of squeegees 22 and 22 to scrape and spread the cream solder on the stencil 7, and squeegee elevating means 10 provided to the beam member 5b for driving a pair of the squeegees 22 and 22 to move up and down.

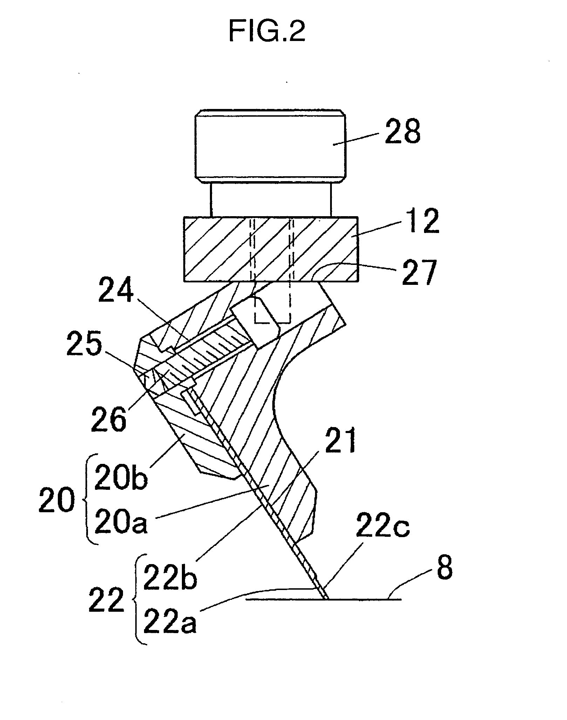

Each of the squeegees 22 and 22 is held by a corresponding squeegee holder 20 (see Fig. 2) inside the squeegee mechanism 5 as will be described below.

A cleaning unit 16 is provided lateral to the substrate supporting unit 3 on the base stand 1. The cleaning unit 16 is provided to be movable between a printing position set at the center of the device (the center in the Y axis direction) and a stand-by position in a lateral portion of the base stand 1 (the position shown in Fig. 1). The cleaning unit 16 is formed so as to be connectable to the substrate supporting unit 3. It is configured in such a manner that the cleaning unit 16 is allowed to move between the printing position and the stand-by position together with the substrate supporting unit 3 when connected to the substrate supporting unit 3 as the necessity arises.

In the printing device configured as above, the substrate supporting unit 3 is first set to a predetermined substrate reception position by an action of the elevating rotation table 4 and the substrate W transported along the conveyers 3A is delivered onto the substrate supporting unit 3.

Subsequently, the substrate supporting unit 3 moves under the stencil 7 and positions the substrate W in the horizontal directions (X and Y directions) and in the rotation direction (R direction) with respect to the stencil 7. Meanwhile, the substrate W is lifted up and the substrate W is superimposed on the back side in the printing region of the stencil 7 and set at the predetermined printing position in this state.

When the substrate W is set in this manner, the squeegees 22 and 22 are placed at predetermined operation start positions within a horizontal plane by an action of the squeegee mechanism 5. Meanwhile, the squeegees 22 and 22 are set at predetermined height positions, that is, at the height positions at which the tip ends of the squeegees 22 and 22 press against the stencil 7, by an action of the squeegee elevating means 10. After the cream solder is supplied onto the stencil 7 from the solder supply device, the squeegees 22 and 22 are driven by the squeegee mechanism 5. Accordingly, the squeegees 22 and 22 slide along the surface of the stencil 7 alternately as each reciprocates in the Y axis direction. The cream solder is thus scraped and spread along the surface of the stencil 7 by the squeegees 22 and 22. In this manner, openings (pattern holes) made in the stencil 7 are filled with the cream solder. The cream solder is consequently applied (printed) on the substrate W at the predetermined positions.

After the cream solder is applied onto the substrate W, the squeegees 22 and 22 are lifted up and reset to the original positions by an action of the squeegee elevating means 10. The substrate supporting unit 3 is then moved to a position at which it can send out the substrate W. A series of printing operations for a single substrate W ends when the substrate W is carried out along the conveyers 3A.

When the printing operations are performed a predetermined number of times, the cleaning unit 16 is connected to the substrate supporting unit 3, and the stencil 7 is cleaned by pulling out the cleaning unit 16 from the stand-by position to the printing position.

The squeegees 22 used in this embodiment and the peripheral structure will now be described in detail. Fig. 2 is an enlarged cross section showing the periphery of one squeegee 22 in the squeegee mechanism 5 of the printing device of this embodiment. As is shown in the drawing, the squeegee 22 is held by the squeegee holder 20 and attached to the squeegee elevating means 10 (see Fig. 1) in a reattachable manner via the squeegee holder 20. The printing device of this embodiment is provided with two squeegees 22 and 22, and because the peripheral structures of the respective squeegees 22 and 22 are substantially the same, only one squeegee 22 and the peripheral structure thereof will be described hereinafter and descriptions will not be repeated.

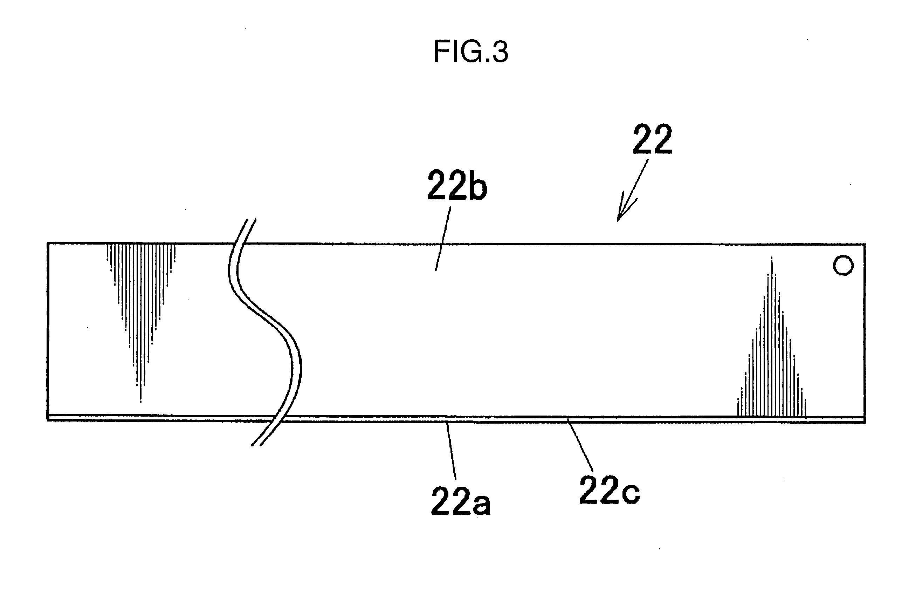

As are shown in Figs. 2 through 4, the squeegee 22 is of a long and slender rectangular shape extending in the X axis direction.

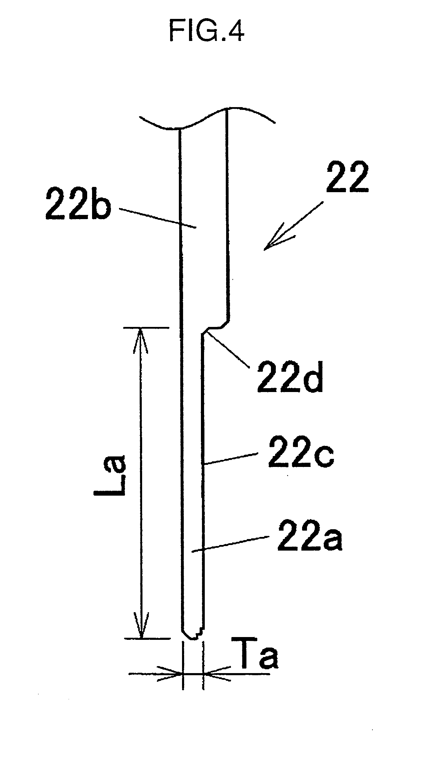

The squeegee 22 has a tip end 22a for scraping the cream solder and a base end 22b provided on the upper side from the tip end 22a. The tip end 22a is made thinner than the base end 22b by a process, such as cutting and grinding, applied only to the back side (the right side in Fig. 2 and Fig. 4). More specifically, of the entire squeegee 22, a portion corresponding to the back side of the tip end 22a is formed as a concave step portion 22c removed by a machining process. The tip end 22a is thus made thinner than the base end 22c by a quantity comparable to the concave step portion 22c (for this reason, the tip end 22a is occasionally referred to as the thinned tip end 22a hereinafter). Consequently, the squeegee 22 is formed as a flat plane continuing from the thinned tip end 22a to the base end 22b on the surface side (non-processed surface side) whereas it is formed as a stepped plane having a step between the tip end 22a and the base end 22b on the back side (processed surface side).

In this embodiment, it is preferable to set the thickness Ta of the thinned tip end 22a to 40 to 120 µm, more preferably to 90 µm or less, and further preferably to 70 µm or less. To be more specific, as will become obvious from an experiment example described below, in a case where the thickness Ta is set within the particular range specified above, it is possible to confer sufficient bending elasticity to the thinned tip end 22a. Accordingly, for example, in a case where the tip end 22a is slid on the half etching mask, it is possible to press the tip end 22a against the mask surface in the half etching portion sunk below the surrounding in a reliable manner. Hence, not only is it possible to achieve a satisfactory scraping ability by letting the tip end 22a follow along the mask surface in a reliable manner, but it is also possible to ensure sufficient durability of the squeegee 22 by conferring predetermined strength to the tip end 22a. In other words, when the thickness Ta is too large, the following ability of the squeegee 22 with respect to the stencil 7 deteriorates due to insufficient bending elasticity of the tip end 22a. This gives rise to an inconvenience, such as cream solder left unscraped, and it becomes difficult to achieve a satisfactory scraping ability. Conversely, when the thickness Ta is too small, the squeegee 22 readily breaks or deteriorates due to deterioration of the mechanical strength of the tip end 22a, which possibly deteriorates the durability, too.

The phrase, "the scraping ability is satisfactory", referred to herein means the ability by which even the inside of the solder pattern hole in the thin mask portion like the half etching portion described above is filled with the solder in a reliable manner, and once the solder pattern hole is filled with the solder, extra solder except for the solder filling inside the solder pattern is scraped completely from the mask surface. With the characteristic as described above, it becomes possible to make the height of the solder printed on the substrate W equal to the mask film thickness. An appropriate solder pattern can be therefore formed on the substrate W.

Also, it is preferable to set the length La of the thinned tip end 22a (the length of the concave step portion 22c) to 0.5 mm or greater, and more preferably to 3.0 mm or less. More specifically, as will become obvious from an experiment example described below, in a case where the length La is set within the particular range specified as above, as with the case of the thickness Ta described above, not only is it possible to achieve a satisfactory scraping ability by ensuring sufficient bending elasticity of the thinned tip end 22a, but it is also possible to ensure sufficient durability of the squeegee 22 by providing predetermined strength to the tip end 22a. In other words, when the length La is too small, a satisfactory scraping ability cannot be achieved due to insufficient bending elasticity of the tip end 22a. Conversely, when the length La is too large, a thinned region is formed in a wide range and the mechanical strength of the tip end 22a deteriorates. The squeegee 22 therefore readily breaks or deteriorates, which possibly deteriorates the durability, too.

As a material of the squeegee 22, an expanded material made of iron and steel, such as a cold rolled steel plate and a hot rolled steel plate, can be used. For example, a plate of Swedish steel or stainless steel manufactured by means of rolling with heating or cooling and having excellent wear resistance and toughness can be used. In a case where Swedish steel is used, plating, such as Ni-P/SiC plating, is applied after the squeegee tip end 22a is made thinner by a machining process.

Meanwhile, as is shown in Fig. 2, the squeegee holder 20 to hold the squeegee 22 includes a holder main body 20a having a mating face 21 for the squeegee 22 at the lower side and a fixing plate 20b to fix the squeegee 22. The back side of the base end of the squeegee 22 is superimposed on the mating face 21 of the holder main body 20a, and further the fixing plate 20b is superimposed on the surface side of the base end of the squeegee 22. In this state, a bolt 26 is inserted into a bolt hole 24 in the holder main body 20a and threaded into a screw hole 25 in the fixing plate 20b. The squeegee 22 is thus pinched by the holder main body 20a and the fixing plate 20b and thereby fixed in the plate thickness direction.

Both of the holder main body 20a and the fixing plate 20b of the squeegee holder 20 are made of light metal, such as aluminum alloy. Both are of a long and slender shape in the X axis direction so that both can hold the squeegee 22 along the longitudinal direction.

A pressing face 27 pressed against the squeegee elevating means 10 is formed on the top portion of the holder main body 20a of the squeegee holder 20. As is shown in Fig. 2, while the pressing face 27 is kept pressed against an attaching face 12a of the attaching plate 12, a bolt 28 is inserted into a bolt hole in the attaching plate 12 and screwed into the top portion of the holder main body 20a. The squeegee holder 20 is thus fixed with respect to the squeegee elevating means 10. In this manner, the squeegee 22 is fixed to the squeegee elevating means 10 via the squeegee holder 20.

In this embodiment, the surface side (non-processed surface side) of the tip end 22a of the squeegee 22 is used as a scraping face. The squeegee 22 is disposed in a forward-tilted posture with the scraping face set on the front side as is shown in Fig. 2, and it is slid along the surface of the stencil 7 in this state.

In the printing device of this embodiment equipped with the squeegee 22 configured as above, even in a case where a half etching mask having a half etching portion, such as a CSP portion sunk partially, is adopted as the stencil 7, the thinned tip end 22a of the squeegee 22 is able to slide along the surface of the stencil 7 precisely and thereby achieves a satisfactory scraping ability.

In other words, when cream solder is migrated along the half etching mask using a normal squeegee, because the bending elasticity of the squeegee tip end is insufficient, the squeegee tip end fails to come inside the hollow, such as the CSP portion, in a reliable manner, and some cream solder is left unscraped. Accordingly, poor printing can occur because cream solder is applied exceedingly or insufficiently.

On the contrary, in the printing device of this embodiment, because the tip end 22a of the squeegee 22 is made thinner, satisfactory elasticity and flexibility can be conferred to the tip end 22a. Accordingly, when the squeegee 22 is slid along the half etching mask, the squeegee tip end 22a comes inside the CSP portion in a reliable manner. Cream solder left unscraped can be thus lessened significantly and solder can be applied onto the substrate W neither exceedingly nor insufficiently. It thus becomes possible to print the solder pattern on the substrate W at a high degree of accuracy, which in turn makes it possible to mount microelectronic components precisely during the component mounting processing in the post-process. A high-quality printed circuit board can be thus provided.

In this embodiment, because the tip end 22a is made thinner by applying a machining process to only one surface side (back side) of the tip end 22a of the squeegee 22, a thinning process can be readily performed. More specifically, in a case where the machining process is applied to the back side of the tip end 22 alone, the back side of the tip end 22a can be processed by using the surface side of the squeegee 22, which is formed of a flat plane, as the reference surface (supporting plane) during the process. An accuracy of the machining process can be thus improved and the thickness can be managed easily at a high degree of accuracy. Because the machining process can be performed easily at a high degree of accuracy as described above, not only can the squeegee 22 be fabricated readily but also the production costs can be reduced. Further, because the machining process is applied to the one surface of the squeegee tip end 22a alone, the thinning process can be completed by applying the process to one surface only once. Hence, in comparison with a case, for example, where the process is applied to the both surfaces two times in total, the squeegee 22 can be fabricated more easily and the production costs can be reduced further.

Also, because the thickness of the tip end 22a can be managed at a high degree of accuracy, it is possible to fabricate the squeegee 22 with high dimensional accuracy in a reliable manner. It thus becomes possible to prevent the quality from varying from one fabricated squeegee to another. The quality can be therefore enhanced further.

In addition, in this embodiment, because the squeegee 22 is slid on the stencil 7 by setting the non-processed surface side of the tip end 22a on the front side, the durability of the squeegee 22 can be enhanced further. More specifically, in a case where the squeegee 22 is slid on the stencil 7 by setting the processed surface side (back side where the concave step portion 22c is formed) of the tip end 22a on the front side, the tip end 22a bends to curve toward the non-processed surface side (the surface side) due to resistance during the sliding. This bending, as is shown in Fig. 4, induces tensile stress (tear stress) such that widely opens an inner corner 22d between the tip end 22a and the base end 22b of the squeegee 22. When such tensile stress acts on the squeegee 22, cracking occurs in the inner corner 22d, which gives rise to early deterioration of the squeegee 22 and hence deterioration of durability.

On the contrary, in this embodiment, because the squeegee 22 is slid on the stencil 7 by setting the non-processed surface side (the surface side) of the tip end 22a on the front side, the tip end 22a bends to curve toward the processed surface side (back side) due to resistance during the sliding. This bending induces compressive stress at the inner corner 22d between the tip end 22a and the base end 22b of the squeegee 22 in such a manner so as to close the inner corner 22d. It is therefore possible to prevent the occurrence of cracking in the inner corner 22d. The durability of the squeegee 22 can be therefore enhanced by preventing early deterioration.

### Experiment Example 1

Hereinafter, an experiment example relating to technical significance of limiting numerical values for the squeegee of the invention will be described.

A squeegee sample having a thinned tip end was prepared using stainless steel (SUS420) with 10-µm-thick Ni/P-plating as a squeegee material (horizontal length of 351.5 mm, the height of 40 mm, and the thickness of 0.22 mm) by applying a machining process to grind the lower edge (tip end) on one surface side (back side) alone. Herein, squeegee samples were prepared by varying the thickness Ta of the thinned tip end by 10 µm in a range of 40 to 140 µm. The length La of the thinned tip end of each squeegee sample was set constant at 1.5 mm.

A half etching mask was set in a printing device same as the printing device of the embodiment above. The respective squeegee samples were then set successively and printing was performed using each sample.

The size (area) of the CSP portion of the half matching mask set in the printing device was 15 mm x 15 mm and a step (hollow depth) was 50 µm.

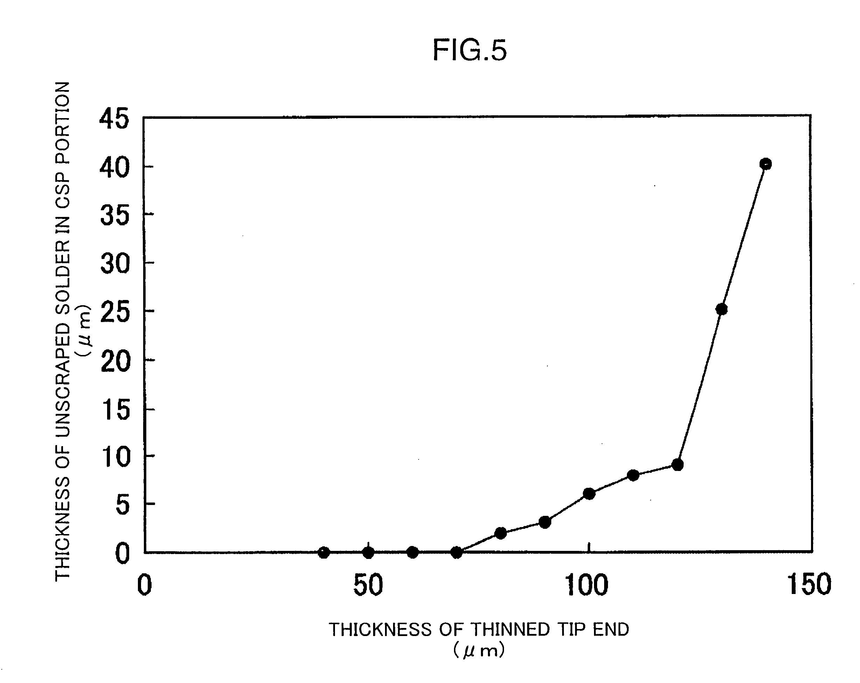

The printing was performed in this manner and the thickness (µm) of cream solder left unscraped in the CSP portion was measured for each squeegee sample. A relation of the thinned tip end thickness (µm) of the squeegee and the unscraped solder thickness (µm) is set forth in Fig. 5 in the form of a graph.

As is obvious from the graph, in a case where a squeegee having the thickness Ta of the thinned tip end of 120 µm or less was used, the thickness of unscraped solder was lessened extremely. In other words, the squeegee tip end was able to come inside the CSP portion in a reliable manner and scraped the cream solder precisely. The printing was thus performed at a high degree of accuracy. In particular, in a case where a squeegee having the thickness of the thinned tip end of 90 µm or less was used, the thickness of unscraped solder was lessened significantly, and in a case where a squeegee having the thickness of the tip end of 70 µm or less was used, substantially no thickness of unscraped solder was confirmed. It was therefore possible to achieve a satisfactory scraping ability.

### Experiment Example 2

Squeegee samples were prepared by applying a process in the same manner as above to a squeegee material same as the one described above while varying the length La of the thinned tip end by 0.1 mm within a range of 0.1 to 3.3 mm. The thickness Ta of the thinned tip end of each squeegee sample was set constant at 50 µm.

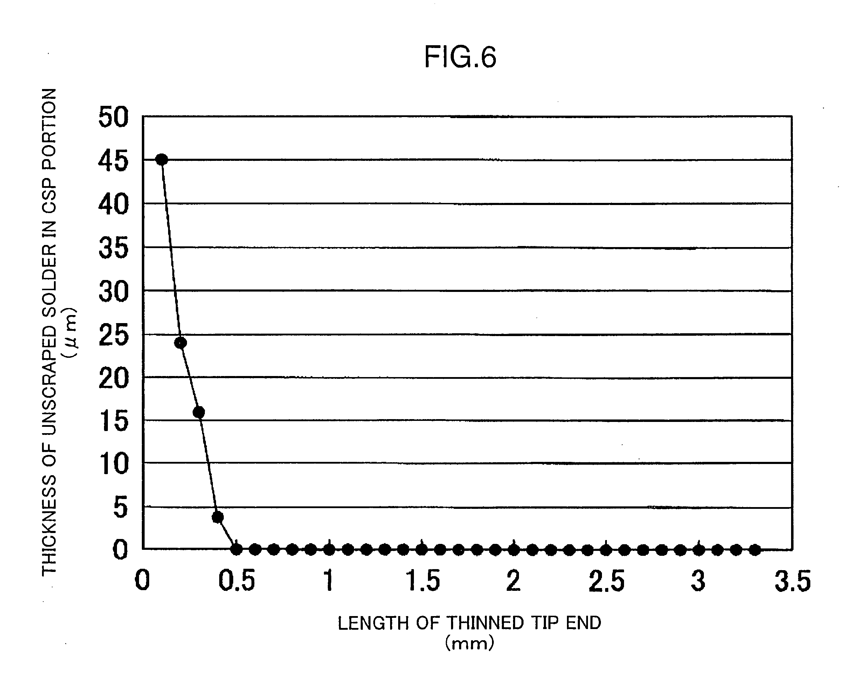

Also, as in the same manner as above, printing was performed using each squeegee sample and the thickness (µm) of solder cream left unscraped in the CSP portion was measured for each squeegee sample. A relation of the length (mm) of the thinned tip end of the squeegee and the thickness (µm) of the unscraped solder is set forth in Fig. 6 in the form of a graph.

As is obvious from the graph, in a case where a squeegee having the length La of the thinned tip end of 0.5 mm or greater was used, substantially no thickness of unscraped solder was confirmed. Hence, the squeegee tip end was able to come inside the CSP portion in a reliable manner and scraped the cream solder precisely. The printing was thus performed at a high degree of accuracy.

By evaluating Experiment Examples 1 and 2 above comprehensively, it is discovered that cream solder on the stencil can be scraped without any irregularity and a satisfactory scraping ability can be achieved when the printing device uses a solder scraping squeegee for which the thickness Ta of the thinned tip end is set to 120 µm or less, more preferably 90 µm or less, and further preferably 70 µm or less and the length La is set to 0.5 mm or greater.

Although it was not described in the experiment examples above, in a case of a squeegee having the thickness of the thinned tip end of less than 40 µm was used, the thinned tip end becomes too thin and the mechanical strength was reduced to the extent that the thinned tip end readily broke or deteriorated. It was therefore difficult to achieve satisfactory durability.

As has been described on the basis of the embodiment above, a squeegee of the invention is a squeegee for a printing device that applies paste on a stencil onto a substrate by spreading the paste by sliding a tip end along a surface of the stencil disposed on the substrate. The squeegee is characterized by: being formed of an expanded material made of iron and steel; making the tip end thinner by applying a machining process to one surface alone; and setting a thickness of the tip end made thinner to 40 to 120 µm and a length thereof to 0. 5 mm or greater.

According to this configuration, by making the squeegee tip end thinner, appropriate bending elasticity can be conferred to this portion. The squeegee tip end is therefore slid while following the surface of the stencil precisely. It thus becomes possible to achieve a satisfactory scraping ability by lessening paste left unscraped. Further, because the machining process is applied only to one surface of the squeegee tip end, in comparison with a case where the machining process is applied to the both surfaces, the process can be performed readily. Hence, not only can the squeegee be fabricated readily, but also the production costs can be reduced.

Also, a printing device of the invention is a printing device that applies paste on a stencil onto a substrate by spreading the paste by sliding a tip end of a squeegee along a surface of the stencil disposed on the substrate. The printing device is **characterized in that**: the squeegee is formed of an expanded material made of iron and steel; the tip end of the squeegee is made thinner by applying a machining process to one surface alone; and a thickness of the tip end made thinner is set to 40 to 120 µm and a length thereof is set to 0.5 mm or greater.

According to this configuration, it is possible to provide a printing device that can achieve the same effect as described above.

Further, a printing method of the invention is a printing method for applying paste on a stencil onto a substrate by spreading the paste by sliding a tip end of a squeegee along a surface of the stencil disposed on the substrate. The printing method is **characterized in that** the squeegee employed is a squeegee that is formed of an expanded material made of iron and steel, in which a tip end is made thinner by applying a machining process to one surface alone, and a thickness of the tip end made thinner is set to 40 to 120 µm and a length thereof is set to 0.5 mm or greater.

According to this configuration, it is possible to provide a printing method that can achieve the same effect as described above.

## Claims

1. A squeegee for a printing device that applies paste on a stencil onto a substrate by spreading the paste by sliding a tip end along a surface of the stencil disposed on the substrate, **characterized by**:
being formed of an expanded material made of iron and steel;
making the tip end thinner by applying a machining process to one surface alone; and
setting a thickness of the tip end made thinner to 40 to 120 µm and a length thereof to 0.5 mm or greater.

2. A printing device that applies paste on a stencil onto a substrate by spreading the paste by sliding a tip end of a squeegee along a surface of the stencil disposed on the substrate, **characterized in that:**
the squeegee is formed of an expanded material made of iron and steel;
the tip end of the squeegee is made thinner by applying a machining process to one surface alone; and
a thickness of the tip end made thinner is set to 40 to 120 µm and a length thereof is set to 0.5 mm or greater.

3. A printing method for applying paste on a stencil onto a substrate by spreading the paste by sliding a tip end of a squeegee along a surface of the stencil disposed on the substrate, **characterized in that:**
the squeegee employed is a squeegee that is formed of an expanded material made of iron and steel, in which a tip end is made thinner by applying a machining process to one surface alone, and a thickness of the tip end made thinner is set to 40 to 120 µm and a length thereof is set to 0.5 mm or greater.
